# EUROPEAN PATENT APPLICATION

(11) **EP 4 152 368 A1**
(43) Date of publication of application: **22.03.2023**
(21) Application number: 22196295.4
(22) Date of filing: 19.09.2022
(51) Int. Cl.: H01L 21/67, C23C 14/56, C23C 16/44

(54) **SUBSTRATE PROCESSING APPARATUS, METHOD OF MANUFACTURING SEMICONDUCTOR DEVICE, AND PROGRAM**

(30) Priority: 21.09.2021 JP 2021152877
(71) Applicant: Kokusai Electric Corp., Tokyo 1010045 (JP)
(72) Inventor: YAMAMOTO, Katsuhiko, Toyama-shi, 9392393 (JP)
(74) Representative: Bardehle Pagenberg Partnerschaft mbB Patentanwälte Rechtsanwälte

(57) **Abstract**

There is provided is a technique includes: at least one processing chamber in which a substrate is processed; a processing gas supplier that supplies a processing gas to the at least one processing chamber; a transfer chamber communicable with the at least one processing chamber; a first inert gas supplier that supplies an inert gas to the transfer chamber; a first exhauster that discharges an atmosphere from the transfer chamber; and a second inert gas supplier that supplies the inert gas discharged by the first exhauster to the at least one processing chamber or a downstream portion of the at least one processing chamber.

## Description

### TECHNICAL FIELD

The present disclosure relates to a substrate processing apparatus, a method of manufacturing a semiconductor device, and a program.

### BACKGROUND

As a substrate processing apparatus used in a step of a semiconductor device manufacturing process, there is an apparatus including a processing chamber that processes a substrate and a transfer chamber communicating with and connected to the processing chamber. In such a configuration, an inert gas may be supplied to the transfer chamber or the processing chamber.

### SUMMARY

The present disclosure provides a technique capable of reducing the consumption amount of an inert gas.

According to one embodiment of the present disclosure, there is provided a technique that includes: at least one processing chamber in which a substrate is processed; a processing gas supplier configured to supply a processing gas to the at least one processing chamber; a transfer chamber communicable with the at least one processing chamber; a first inert gas supplier configured to supply an inert gas to the transfer chamber; a first exhauster configured to discharge an atmosphere from the transfer chamber; and a second inert gas supplier configured to supply the inert gas discharged by the first exhauster to the at least one processing chamber or a downstream portion of the at least one processing chamber.

### BRIEF DESCRIPTION OF DRAWINGS

The accompanying drawings, which are incorporated in and constitute a part of the specification, illustrate embodiments of the present disclosure.
FIG. 1 is a transverse cross-sectional view illustrating an overall configuration example of a substrate processing apparatus according to a first embodiment of the present disclosure.
FIG. 2 is a longitudinal cross-sectional view illustrating an overall configuration example of the substrate processing apparatus according to the first embodiment of the present disclosure.
FIG. 3 is an explanatory diagram schematically illustrating an example of a schematic configuration of a processing chamber of the substrate processing apparatus according to the first embodiment of the present disclosure.
FIG. 4 is an explanatory diagram schematically illustrating a configuration example of main components of a gas supply system and a gas exhaust system of the substrate processing apparatus according to the first embodiment of the present disclosure.
FIG. 5 is a flowchart illustrating an outline of a substrate processing step according to the first embodiment of the present disclosure.
FIG. 6 is a flowchart illustrating details of a film forming step in the substrate processing step of FIG. 5.
FIG. 7 is an explanatory diagram schematically illustrating a configuration example of main components of a gas supply system and a gas exhaust system of a substrate processing apparatus according to a second embodiment of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

Hereinafter, embodiments of the present disclosure will be described with reference to the drawings. In the following description, the same components may be designated by like reference numerals and the repeated description thereof may be omitted.

A substrate processing apparatus exemplified in the following description is used in a semiconductor device manufacturing process, and is configured to perform predetermined processing on a substrate to be processed.

The substrate to be processed is, for example, a silicon wafer (hereinafter, simply referred to as a "substrate") serving as a semiconductor substrate in which a semiconductor device is built. In the present specification, the term "substrate" may mean "a substrate itself" or "a laminate (assembly) of a substrate and a predetermined layer, film, or the like formed on a surface of the substrate" (that is, a substrate with a predetermined layer, film, or the like formed on a surface thereof is referred to as a substrate). In the present specification, the term "surface of a substrate" may mean "a surface (exposed surface) of a substrate itself" or "a surface of a predetermined layer, film, or the like formed on a substrate, that is, an outermost surface of a substrate serving as a laminate". In the present specification, the term "wafer" is synonymous with the term "substrate".

Examples of the predetermined processing (hereinafter, also simply referred to as "processing") performed on a substrate include oxidizing processing, diffusing processing, annealing processing, etching processing, pre-cleaning processing, chamber cleaning processing, and film forming processing. In the present embodiment, in particular, a case where film forming processing is performed will be exemplified.

### <First Embodiment>

First, a first embodiment of the present disclosure will be specifically described.

### (1) Overall configuration of substrate processing apparatus

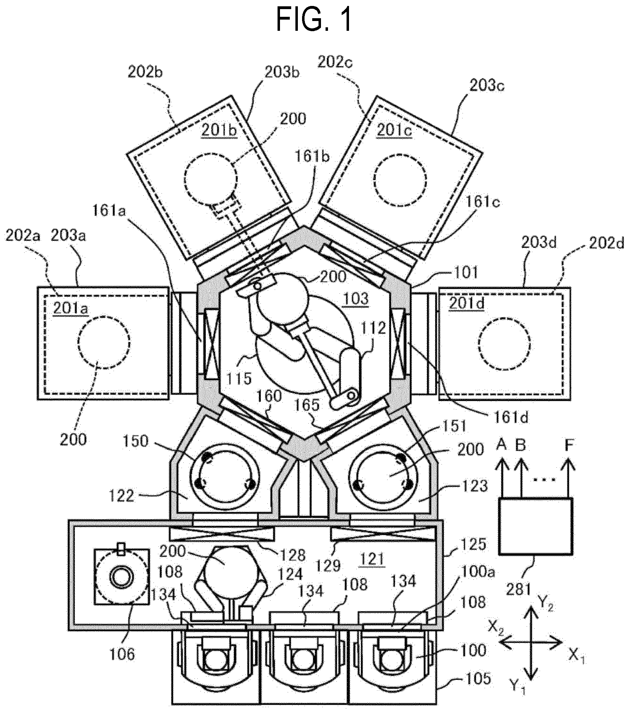

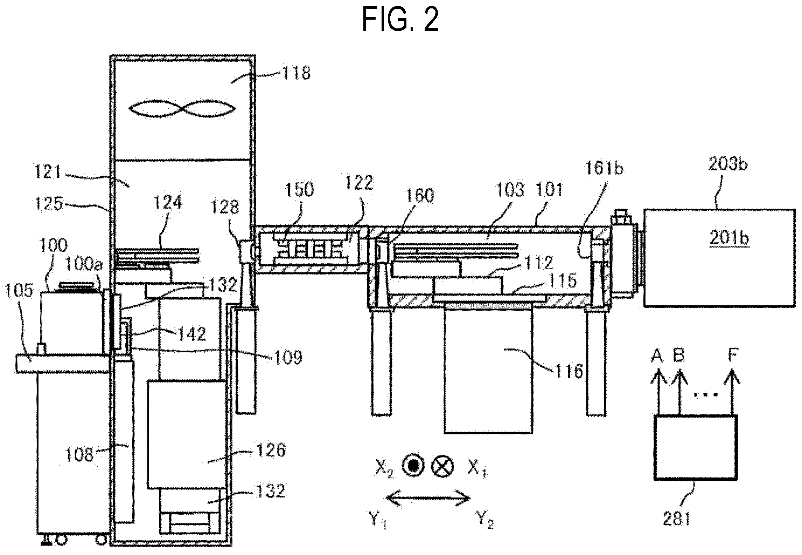

An overall configuration of a substrate processing apparatus according to the first embodiment of the present disclosure will be described with reference to FIGS. 1 and 2. FIG. 1 is a transverse cross-sectional view illustrating an overall configuration example of the substrate processing apparatus according to the first embodiment. FIG. 2 is a longitudinal cross-sectional view illustrating an overall configuration example of the substrate processing apparatus according to the first embodiment.

As illustrated in FIGS. 1 and 2, the substrate processing apparatus described herein as an example is a so-called cluster type substrate processing apparatus including a plurality of processing modules 201a to 201d around a vacuum transfer chamber 103. More specifically, the substrate processing apparatus in the illustrated example processes a substrate 200, and roughly includes the vacuum transfer chamber (transfer module) 103, load lock chambers (load lock modules) 122 and 123, an atmospheric transfer chamber (front end module) 121, an IO stage (load port) 105, the plurality of processing modules (process modules) 201a to 201d, and a controller 281.

Each of these components will be specifically described below. In the following description, an X1 direction is the right, an X2 direction is the left, a Y1 direction is the front, and a Y2 direction is the rear as for the front, rear, left, and right.

### (Vacuum transfer chamber)

The vacuum transfer chamber 103 functions as a transfer chamber serving as a carry space in which the substrate 200 is carried under negative pressure. A housing 101 constituting the vacuum transfer chamber 103 is formed in a hexagonal shape in a plan view. To sides of the hexagon, the load lock chambers 122 and 123 and the processing modules 201a to 201d are connected via gate valves 160, 165, and 161a to 161d, respectively.

At a substantially central portion of the vacuum transfer chamber 103, a vacuum transfer robot 112 serving as a transfer robot that transfers (carries) the substrate 200 under negative pressure is disposed with a flange 115 as a base. The vacuum transfer robot 112 is configured to be raised or lowered by an elevator 116 and the flange 115 while maintaining airtightness of the vacuum transfer chamber 103 (see FIG. 2).

### (Load lock chamber)

The load lock chamber 122 for loading and the load lock chamber 123 for unloading are connected to two side walls located on a front side among six side walls of the housing 101 constituting the vacuum transfer chamber 103 via the gate valves 160 and 165, respectively. A substrate mounting table 150 for loading is disposed in the load lock chamber 122, and a substrate mounting table 151 for unloading is disposed in the load lock chamber 123. Each of the load lock chambers 122 and 123 is configured to be able to withstand negative pressure.

### (Atmospheric transfer chamber)

The atmospheric transfer chamber 121 is connected to front sides of the load lock chambers 122 and 123 via gate valves 128 and 129, respectively. The atmospheric transfer chamber 121 is used under substantially atmospheric pressure.

In the atmospheric transfer chamber 121, an atmospheric transfer robot 124 that transfers the substrate 200 is disposed. The atmospheric transfer robot 124 is configured to be raised or lowered by an elevator 126 disposed in the atmospheric transfer chamber 121, and is configured to be reciprocated in a left-right direction by a linear actuator 132 (see FIG. 2).

In an upper portion of the atmospheric transfer chamber 121, a cleaner 118 that supplies clean air is disposed (see FIG. 2). On a left side of the atmospheric transfer chamber 121, a device (hereinafter, referred to as a "pre-aligner") 106 that aligns a notch or an orientation flat formed on the substrate 200 is disposed (see FIG. 1).

### (IO stage)

On a front side of a housing 125 of the atmospheric transfer chamber 121, a substrate loading/unloading port 134 for loading/unloading the substrate 200 into/from the atmospheric transfer chamber 121 and a pod opener 108 are disposed. On a side opposite to the pod opener 108 across the substrate loading/unloading port 134, that is, on an outer side of the housing 125, the IO stage 105 is disposed.

On the IO stage 105, a plurality of front opening unified pods (FOUP, hereinafter referred to as "pod") 100 that stores a plurality of the substrates 200 is mounted. The pod 100 is used as a carrier that carries the substrate 200 such as a silicon (Si) substrate. The pod 100 is configured to store a plurality of unprocessed substrates 200 and a plurality of processed substrates 200 in a horizontal posture therein. The pod 100 is supplied to and discharged from the IO stage 105 by an in-process carry device (RGV) (not illustrated).

The pod 100 on the IO stage 105 is opened and closed by the pod opener 108. The pod opener 108 includes a closure 142 capable of opening and closing a cap 100a of the pod 100 and closing the substrate loading/unloading port 134, and a driver 109 that drives the closure 142. The pod opener 108 opens and closes the cap 100a of the pod 100 mounted on the IO stage 105 to open and close the substrate loading/unloading port, thereby making it possible to load/unload the substrate 200 into/from the pod 100.

### (Processing module)

To remaining four side walls to which the load lock chambers 122 and 123 are not connected among the six side walls of the housing 101 constituting the vacuum transfer chamber 103, the processing modules 201a to 201d that perform desired processing on the substrate 200 are connected via the gate valves 161a to 161d so as to be located radially around the vacuum transfer chamber 103, respectively. The processing modules 201a to 201d are constituted by cold wall type processing containers 203a to 203d, and processing chambers 202a to 202d are formed therein, respectively. In each of the processing chambers 202a to 202d, the substrate 200 is processed as one step of a semiconductor or semiconductor device manufacturing process. Examples of the processing performed in each of the processing chambers 202a to 202d include various types of substrate processing such as processing of forming a thin film on a substrate, processing of oxidizing, nitriding, carbonizing, or the like a substrate surface, formation of a film formed of a silicide, a metal, or the like, processing of etching a substrate surface, and reflow processing.

A detailed configuration of each of the processing modules 201a to 201d will be described later.

### (Controller)

The controller 281 configured to be capable of controlling operations of components constituting the substrate processing apparatus 10. Therefore, the controller 281 serving as a control structure is constituted by a computer device including a central processing unit (CPU), a random access memory (RAM), and the like.

A detailed configuration of the controller 281 will be described later.

### (2) Configuration of processing module

Next, a detailed configuration of each of the processing modules 201a to 201d will be described.

The processing modules 201a to 201d each function as a single wafer type substrate processing apparatus, and have configurations similar to each other.

Here, a specific configuration of one of the processing modules 201a to 201d will be described as an example. One of the processing modules 201a to 201d will be taken as an example. Therefore, in the following description, the processing modules 201a to 201d will be simply described as "processing module 201", the cold wall type processing containers 203a to 203d constituting the processing modules 201a to 201d, respectively, will be simply described as "processing container 203", the processing chambers 202a to 202d formed in the processing containers 203a to 203d, respectively, will be simply described as "processing chamber 202", and the gate valves 161a to 161d corresponding to the processing modules 201a to 201d, respectively, will be simply described as "gate valve 161".

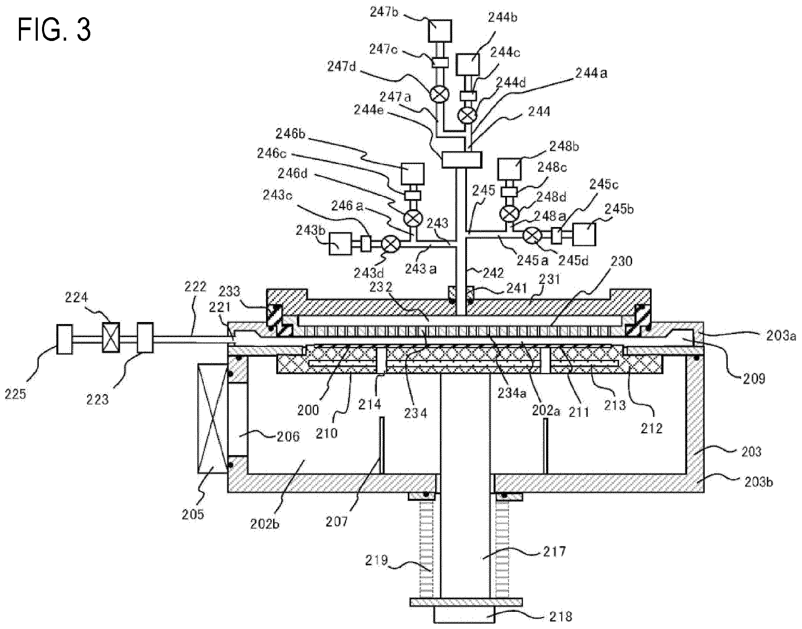

FIG. 3 is an explanatory diagram schematically illustrating an example of a schematic configuration of the processing chamber of the substrate processing apparatus according to the first embodiment.

### (Processing container)

As described above, the processing module 201 is constituted by the cold wall type processing container 203. The processing container 203 is made of a metal material such as aluminum (Al) or stainless steel (SUS), for example, as a flat sealed container having a circular cross section. The processing container 203 includes an upper container 203a and a lower container 203b.

The processing chamber 202 is formed in the processing container 203. The processing chamber 202 includes a processing space 202a which is located on an upper side of the processing chamber 202 (in a space above a substrate mounting table 212 described later) and processes the substrate 200 such as a silicon wafer, and a carry space 202b which is a space surrounded by a lower container 203b on a lower side of the processing chamber 202.

Near an outer peripheral edge inside the upper container 203a, an exhaust buffer chamber 209 is disposed. The exhaust buffer chamber 209 functions as a buffer space when a gas in the processing chamber 202 is discharged toward a side periphery. Therefore, the exhaust buffer chamber 209 has a space formed so as to surround a side outer periphery of the processing chamber 202. That is, the exhaust buffer chamber 209 has a space formed in a ring shape (annular shape) in a plan view on an outer peripheral side of the processing chamber 202.

A side surface of the lower container 203b, that is, one of walls constituting the processing container 203 has a substrate loading/unloading port 206 adjacent to the gate valve 205 is formed. The substrate 200 is loaded into the carry space 202b via the substrate loading/unloading port 206. At a bottom of the lower container 203b, a plurality of lift pins 207 is disposed.

### (Substrate support)

The processing chamber 202 includes a substrate support (susceptor) 210 that supports the substrate 200 therein. The substrate support 210 mainly includes a substrate mounting surface 211 on which the substrate 200 is mounted, a substrate mounting table 212 having the substrate mounting surface 211 on a surface thereof, and a heater 213 serving as a heating source included in the substrate mounting table 212. In the substrate mounting table 212, through-holes 214 through which the lift pins 207 pass are formed at positions corresponding to the lift pins 207, respectively.

The substrate mounting table 212 is supported by a shaft 217. The shaft 217 passes through a bottom of the processing container 203, and is further connected to an elevator 218 outside the processing container 203. By operating the elevator 218 to raise or lower the shaft 217 and the substrate mounting table 212, the substrate mounting table 212 can raise or lower the substrate 200 mounted on the substrate mounting surface 211. A periphery of a lower end of the shaft 217 is covered with bellows 219, and the inside of the processing container 203 is airtightly held.

The substrate mounting table 212 is lowered to a position (substrate carry position) where the substrate mounting surface 211 faces the substrate loading/unloading port 206 at a time of carrying the substrate 200, and is raised until the substrate 200 reaches a processing position (substrate processing position) in the processing space 202a at a time of processing the substrate 200.

Specifically, when the substrate mounting table 212 is lowered to the substrate carry position, an upper end of the lift pin 207 protrudes from an upper surface of the substrate mounting surface 211, and the lift pin 207 supports the substrate 200 from below. When the substrate mounting table 212 is raised to the substrate processing position, the lift pin 207 is buried into the upper surface of the substrate mounting surface 211, and the substrate mounting surface 211 supports the substrate 200 from below.

### (Shower head)

Above the processing space 202a (on an upstream side in a gas supply direction), a shower head 230 serving as a gas dispersion mechanism is disposed. A lid 231 of the shower head 230 has a gas introduction port 241. The gas introduction port 241 is configured such that a gas supply system described later communicates therewith. A gas introduced from the gas introduction port 241 is supplied to a buffer space 232 of the shower head 230.

The lid 231 of the shower head 230 is made of a conductive metal, and is used as an electrode for generating plasma in the buffer space 232 or the processing space 202a. Between the lid 231 and the upper container 203a, an insulating block 233 is disposed to insulate the lid 231 and the upper container 203a from each other.

The shower head 230 includes a dispersion plate 234 for dispersing a gas supplied from a gas supply system via the gas introduction port 241. An upstream side of the dispersion plate 234 is the buffer space 232, and a downstream side thereof is the processing space 202a. The dispersion plate 234 has a plurality of through-holes 234a. The dispersion plate 234 is disposed so as to face the substrate mounting surface 211.

### (Gas supply system)

A common gas supply pipe 242 is connected to the lid 231 of the shower head 230 so as to communicate with the gas introduction port 241. The common gas supply pipe 242 communicates with the buffer space 232 in the shower head 230 via the gas introduction port 241. To the common gas supply pipe 242, a first gas supply pipe 243a, a second gas supply pipe 244a, and a third gas supply pipe 245a are connected. Among these pipes, the second gas supply pipe 244a is connected to the common gas supply pipe 242 via a remote plasma unit (plasma generator) 244e.

Among these, from a source gas supply system 243 including the first gas supply pipe 243a, a source gas, which is one of processing gases, is mainly supplied, and from a reactant gas supply system 244 including the second gas supply pipe 244a, a reactant gas, which is another one of the processing gases, is mainly supplied. From a purge gas supply system 245 including the third gas supply pipe 245a, an inert gas serving as a purge gas is mainly supplied when the substrate 200 is processed, and a cleaning gas is mainly supplied when the shower head 230 and the processing chamber 202 are cleaned. As for a gas supplied from a gas supply system, the source gas may be referred to as a first gas, the reactant gas may be referred to as a second gas, the inert gas may be referred to as a third gas, and the cleaning gas may be referred to as a fourth gas.

### (Source gas supply system)

The first gas supply pipe 243a includes a source gas supply source 243b, a mass flow controller (MFC) 243c which is a flow rate controller, and a valve 243d that is an on-off valve in this order from an upstream side. A source gas is supplied from the first gas supply pipe 243a into the shower head 230 via the MFC 243c, the valve 243d, and the common gas supply pipe 242.

The source gas (first gas) is one of the processing gases, and is, for example, a gas containing a silicon (Si) element serving as a first element. Specifically, a dichlorosilane (SiH₂Cl₂, DCS) gas, a tetraethoxysilane (Si(OC₂H₅)₄, TEOS) gas, or the like is used. In the following description, an example using a DCS gas will be described.

Mainly, the first gas supply pipe 243a, the MFC 243c, and the valve 243d constitute the source gas supply system 243. The source gas supply system 243 may include the source gas supply source 243b and an inert gas supply system described later. Since the source gas supply system 243 supplies the source gas, which is one of the processing gases, the source gas supply system 243 corresponds to one of processing gas supply systems (processing gas suppliers).

To a downstream side of the valve 243d of the first gas supply pipe 243a, a downstream end of an inert gas supply pipe 246a is connected. The inert gas supply pipe 246a includes an inert gas supply source 246b, an MFC 246c, and a valve 246d in this order from an upstream side. From the inert gas supply pipe 246a, an inert gas is supplied into the shower head 230 via the MFC 246c, the valve 246d, and the first gas supply pipe 243a.

The inert gas acts as a carrier gas of the source gas, and it is preferable to use a gas that does not react with the source. Specifically, for example, a nitrogen (N₂) gas can be used. In addition to the N₂ gas, for example, a rare gas such as a helium (He) gas, a neon (Ne) gas, or an argon (Ar) gas can be used.

Mainly, the inert gas supply pipe 246a, the MFC 246c, and the valve 246d constitute the inert gas supply system. The inert gas supply system may include the inert gas supply source 246b and the first gas supply pipe 243a. The inert gas supply system may be included in the source gas supply system 243.

### (Reactant gas supply system)

The second gas supply pipe 244a includes an RPU 244e on a downstream of the second gas supply pipe 244a. The second gas supply pipe 244a includes a reactant gas supply source 244b, an MFC 244c, and a valve 244d on an upstream of the second gas supply pipe 244a in this order from an upstream side. From the second gas supply pipe 244a, a reactant gas is supplied into the shower head 230 via the MFC 244c, the valve 244d, the RPU 244e, and the common gas supply pipe 242. The reactant gas is brought into a plasma state by the remote plasma unit 244e, and is emitted on a surface of the substrate 200.

The reactant gas (second gas) is another one of the processing gases, and is a gas containing a second element (for example, nitrogen) different from the first element (for example, Si) contained in the source gas. Specifically, for example, an ammonia (NH₃) gas which is a nitrogen (N)-containing gas is used.

Mainly, the second gas supply pipe 244a, the MFC 244c, and the valve 244d constitute the reactant gas supply system 244. The reactant gas supply system 244 may include the reactant gas supply source 244b, the RPU 244e, and an inert gas supply system described later. Since the reactant gas supply system 244 supplies the reactant gas, which is one of the processing gases, the reactant gas supply system 244 corresponds to another one of the processing gas supply systems (processing gas suppliers).

On a downstream side of the second gas supply pipe 244a than the valve 244d, a downstream end of an inert gas supply pipe 247a is connected. The inert gas supply pipe 247a includes an inert gas supply source 247b, an MFC 247c, and a valve 247d in this order from an upstream side. From the inert gas supply pipe 247a, an inert gas is supplied into the shower head 230 via the MFC 247c, the valve 247d, the second gas supply pipe 244a, and the RPU 244e.

The inert gas acts as a carrier gas or a dilution gas of the reactant gas. Specifically, for example, a N₂ gas can be used. In addition to the N₂ gas, for example, a rare gas such as a He gas, a Ne gas, or an Ar gas may be used.

Mainly, the inert gas supply pipe 247a, the MFC 247c, and the valve 247d constitute the inert gas supply system. The inert gas supply system may include the inert gas supply source 247b, the second gas supply pipe 244a, and the RPU 244e. The inert gas supply system may be included in the reactant gas supply system 244.

### (Purge gas supply system)

The third gas supply pipe 245a includes a purge gas supply source 245b, an MFC 245c, and a valve 245d in this order from an upstream side of the third gas supply pipe 245a. In a substrate processing step, from the third gas supply pipe 245a, an inert gas serving as a purge gas is supplied into the shower head 230 via the MFC 245c, the valve 245d, and the common gas supply pipe 242. In a processing space cleaning step, an inert gas serving as a carrier gas or a dilution gas of the cleaning gas is supplied into the shower head 230 via the MFC 245c, the valve 245d, and the common gas supply pipe 242.

In the substrate processing step, the inert gas supplied from the purge gas supply source 245b acts as a purge gas that discharges a gas remaining in the processing container 203 and the shower head 230. In the processing space cleaning step, the inert gas supplied from the purge gas supply source 245b may act as a carrier gas or a dilution gas of the cleaning gas. Specifically, for example, a N₂ gas can be used as the inert gas. In addition to the N₂ gas, for example, a rare gas such as a He gas, a Ne gas, or an Ar gas may be used.

Mainly, the third gas supply pipe 245a, the MFC 245c, and the valve 245d constitute the purge gas supply system 245. The purge gas supply system 245 may include the purge gas supply source 245b and a cleaning gas supply system 248 described later.

The inert gas supplied from the purge gas supply source 245b includes an inert gas discharged from the vacuum transfer chamber 103 as described in detail later. That is, the purge gas supply system 245 functions as a second inert gas supply system (second inert gas supplier) that supplies the inert gas discharged from the vacuum transfer chamber 103 to the processing chamber 202.

### (Cleaning gas supply system)

To a downstream side of the valve 245d of the third gas supply pipe 245a, a downstream end of a cleaning gas supply pipe 248a is connected. The cleaning gas supply pipe 248a includes a cleaning gas supply source 248b, an MFC 248c, and a valve 248d in this order from an upstream side. In the processing space cleaning step, from the third gas supply pipe 245a, a cleaning gas is supplied into the shower head 230 via the MFC 248c, the valve 248d, and the common gas supply pipe 242.

In the processing space cleaning step, a cleaning gas (fourth gas) supplied from the cleaning gas supply source 248b acts as a cleaning gas that removes a by-product and the like adhering to the shower head 230 or the processing container 203. Specifically, for example, it is conceivable to use a nitrogen trifluoride (NF₃) gas as the cleaning gas. For example, a hydrogen fluoride (HF) gas, a chlorine trifluoride (ClF₃) gas, a fluorine (F₂) gas, or the like may be used, or a combination thereof may be used.

Mainly, the cleaning gas supply pipe 248a, the MFC 248c, and the valve 248d constitute the cleaning gas supply system (cleaning gas supplier) 248. The cleaning gas supply system 248 may include the cleaning gas supply source 248b and the third gas supply pipe 245a. The cleaning gas supply system 248 may be included in the purge gas supply system 245.

The cleaning gas supplied from the cleaning gas supply system 248 is supplied to the processing chamber 202 through the shower head 230. That is, the cleaning gas supply system 248 functions as a cleaning gas supplier that supplies the cleaning gas to the processing chamber 202.

Here, an example of a configuration has been described in which the processing chamber 202 communicates with each of the source gas supply system 243, the reactant gas supply system 244, the purge gas supply system 245, and the processing space cleaning gas supply system 248 via the common gas supply pipe (first supply pipe) 242, but the present disclosure is not necessarily limited thereto. For example, a gas supply pipe in each of the source gas supply system 243, the reactant gas supply system 244, the purge gas supply system 245, and the processing space cleaning gas supply system 248 may be directly connected to the shower head 230, the processing chamber 202, and the like.

### (Gas exhaust system)

To the processing container 203, an exhaust pipe 222 is connected. The exhaust pipe 222 is connected to the inside of the exhaust buffer chamber 209 via an exhaust port 221 formed on an upper surface or a side of the exhaust buffer chamber 209. As a result, the exhaust pipe 222 communicates with the inside of the processing chamber 202.

The exhaust pipe 222 includes an auto pressure controller (APC) valve 223 which is a pressure controller that controls the pressure in the processing chamber 202 communicating with the exhaust buffer chamber 209 to a predetermined pressure. The APC valve 223 has a valve body (not illustrated) whose opening degree is adjustable, and adjusts conductance of the exhaust pipe 222 according to an instruction from the controller 281 described later. Hereinafter, the APC valve 223 disposed in the exhaust pipe 222 may be simply referred to as a valve 223.

In the exhaust pipe 222, a vacuum pump 224 is disposed on a downstream side of the APC valve 223. The vacuum pump 224 discharges an atmosphere from the exhaust buffer chamber 209 and the processing chamber 202 communicating therewith via the exhaust pipe 222. As a result, the exhaust pipe 222 functions as an exhaust pipe that discharges a gas from the processing chamber 202.

Furthermore, on a downstream side of the vacuum pump 224, a scrubber 225 is disposed. The scrubber 225 functions as a detoxification apparatus that purifies (cleans) a gas discharged through the exhaust pipe 222.

Mainly, the exhaust pipe 222, the APC valve 223, the vacuum pump 224, and the scrubber 225 constitute a gas exhaust system.

### (3) Configurations of other gas supply system and other gas exhaust system

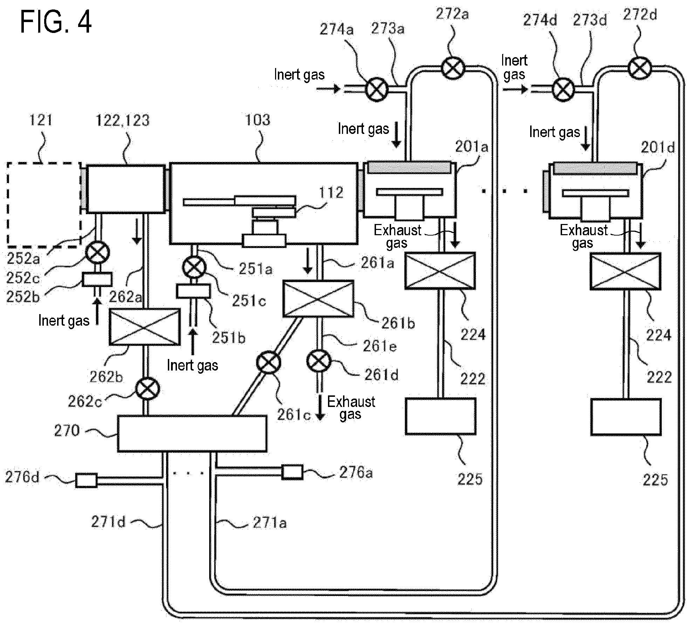

Next, a gas supply system and a gas exhaust system other than the above-described configurations will be described with reference to FIG. 4. FIG. 4 is an explanatory diagram schematically illustrating a configuration example of main components of a gas supply system and a gas exhaust system of the substrate processing apparatus according to the first embodiment.

### (First inert gas supply system)

The substrate processing apparatus described in the present embodiment can supply an inert gas also to a transfer chamber communicable with the above-described processing modules 201a to 201d in addition to the processing modules 201a to 201d.

Therefore, to the vacuum transfer chamber 103 functioning as a transfer chamber, an inert gas supply pipe 251a is connected. The inert gas supply pipe 251a includes an MFC 251b and a valve 251c, and further includes an inert gas supply source (not illustrated) on an upstream side thereof. The inert gas supply source may be the purge gas supply source 245b of the purge gas supply system 245. As an inert gas to be supplied to the vacuum transfer chamber 103, for example, a N₂ gas can be used. In addition to the N₂ gas, for example, a rare gas such as a He gas, a Ne gas, or an Ar gas may be used.

Similarly to the vacuum transfer chamber 103, an inert gas supply pipe 252a is connected to the load lock chambers 122 and 123 functioning as transfer chambers. The inert gas supply pipe 252a includes an MFC 252b and a valve 252c, and further includes an inert gas supply source (not illustrated) on an upstream side thereof. The inert gas supply source may be the purge gas supply source 245b of the purge gas supply system 245. For example, a N₂ gas can be used as an inert gas to be supplied to the load lock chambers 122 and 123. In addition to the N₂ gas, for example, a rare gas such as a He gas, a Ne gas, or an Ar gas may be used.

Mainly, the inert gas supply pipe 251a, the MFC 251b, and the valve 251c constitute a first inert gas supply system (first inert gas supplier). The first inert gas supply system may include the inert gas supply source. The first inert gas supply system may include the inert gas supply pipe 252a, the MFC 252b, the valve 252c, and the inert gas supply source that supply a gas to the load lock chambers 122 and 123.

### (First exhaust system)

The substrate processing apparatus described in the present embodiment can not only supply an inert gas to the transfer chamber as described above but also can discharge an atmosphere from the transfer chamber.

Therefore, to the vacuum transfer chamber 103 functioning as a transfer chamber, an exhaust pipe 261a is connected. The exhaust pipe 261a includes a vacuum pump 261b. The vacuum pump 261b discharges an atmosphere from the vacuum transfer chamber 103 via the exhaust pipe 261a. On a downstream side of the vacuum pump 261b, the exhaust pipe 261a is bifurcated. The branches include valves 261c and 261d, respectively, and an exhaust pipe 261a, which is one of the branches, is connected to a filter 270 described later.

Similarly to the vacuum transfer chamber 103, an exhaust pipe 262a is connected to the load lock chambers 122 and 123 functioning as transfer chambers. The exhaust pipe 262a includes a vacuum pump 262b. The vacuum pump 262b discharges an atmosphere from the load lock chambers 122 and 123 via the exhaust pipe 262a. On a downstream side of the vacuum pump 262b, a valve 262c is disposed. On a downstream side of the vacuum pump 262b, the exhaust pipe 262a may be bifurcated similarly to the above-described exhaust pipe 261a.

Mainly, the exhaust pipe 261a, the vacuum pump 261b, and the valves 261c and 261d that perform exhaust from the vacuum transfer chamber 103 constitute a first exhaust system (first exhauster). The first exhaust system may include the exhaust pipe 262a, the vacuum pump 262b, and the valve 262c that perform exhaust from the load lock chambers 122 and 123.

### (Second inert gas supply system)

The substrate processing apparatus described in the present embodiment can supply an inert gas discharged from the transfer chamber to the processing chambers 202a to 202d formed in the processing modules 201a to 201d, respectively.

Therefore, the filter 270 is disposed on downstream sides of the exhaust pipes 261a and 262a constituting the first exhaust system. To the filter 270, inert gas supply pipes 271a to 271d disposed corresponding to the processing modules 201a to 201d, respectively, are connected. In the drawing, the inert gas supply pipe 271a corresponding to the processing module 201a and the inert gas supply pipe 271d corresponding to the processing module 201a are illustrated, and the others are not illustrated.

The inert gas supply pipe 271a includes a valve 272a. A downstream end of the inert gas supply pipe 271a is connected to the purge gas supply system 245 in the processing module 201a. As a result, an inert gas discharged by the first exhauster is supplied by the inside of the shower head 230 of the processing module 201a into the processing chamber 202 through the inert gas supply pipe 271a. That is, the inert gas supply pipe 271a is connected to the third gas supply pipe 245a of the purge gas supply system 245 in the processing module 201a, or functions as the purge gas supply source 245b of the purge gas supply system 245.

The other inert gas supply pipes including the inert gas supply pipe 271d are configured similarly to the above-described inert gas supply pipe 271a. That is, the inert gas supply pipes 271a to 271d supply an inert gas to the processing chambers 202a to 202d in the processing modules 201a to 201d, respectively. However, as the inert gas, a gas discharged by the first exhaust system is mainly used.

Mainly, the inert gas supply pipes 271a to 271d and the valves 272a to 272d disposed in the inert gas supply pipes 271a to 271d, respectively, constitute a second inert gas supply system (second inert gas supplier). The second inert gas supply system may include the filter 270, and communicates with the first exhaust system via the filter 270.

To the inert gas supply pipes 271a to 271d in the second inert gas supply system, inert gas replenishing pipes 273a to 273d may be connected on upstream sides of the valves 272a to 272d, respectively. The inert gas replenishing pipes 273a to 273d include valves 274a to 274d, respectively, and further each include an inert gas supply source (not illustrated) on an upstream side thereof. The inert gas supply source is disposed for replenishing each of the inert gas supply pipes 271a to 271d with an inert gas (for example, a N₂ gas, a He gas, a Ne gas, or an Ar gas) flowing through each of the inert gas supply pipes 271a to 271d, and the purge gas supply source 245b of the purge gas supply system 245 may be used. More preferably, the inert gas replenishing pipes 273a to 273d are desirably connected to downstream sides of the valves 272a to 272d, respectively. When an inert gas is supplied from each of the inert gas replenishing pipes 273a to 273d while each of the valves 272a to 272d is throttled, formation of a flow of the inert gas to the filter 270 is suppressed, and thus the pressure of each of the processing chambers 202 can be easily adjusted.

Mainly, the inert gas replenishing pipes 273a to 273d and the valves 274a to 274d disposed in these pipes constitute an inert gas replenishing system (inert gas replenisher) capable of replenishing an inert gas. The inert gas replenishing system may be included in the second inert gas supply system (second inert gas supplier).

### (4) Configuration of controller

Next, a detailed configuration of the controller 281 will be described.

As described above, the controller 281 functions as a controller that controls operations of the units constituting the substrate processing apparatus, and is constituted by a computer device including at least a calculator, a memory, and the like. The controller 281 is connected to each of the above-describe components of the substrate processing apparatus, calls a program or a recipe from a memory according to an instruction of a host apparatus or a user, and controls the operation of each of the components according to the content thereof.

Specifically, the controller 281 is electrically connected to each of the vacuum transfer robot 112, the atmospheric transfer robot 124, the gate valves 160, 161a, 161b, 161c, 161d, 165, 128, and 129, the pod opener 108, the pre-aligner 106, and the cleaner 118, and is configured to give an operation instruction to each of these units.

In addition, the controller 281 is electrically connected to each of the elevator 218, the heater 213, the MFCs 243c to 248c, the valves 243d to 248d, the MFCs 249c, 251b, and 252b, the valves 243d to 248d, 251c, 252c, 261c, 261d, 262c, and 274a to 274d, the APC valve 223, the vacuum pumps 224, 261b, and 262b, and the like of the processing modules 201a to 201d, and is configured to give an operation instruction to each of these units. That is, what is controlled by the controller 281 includes at least gas supply from the gas supply system, gas exhaust by the gas exhaust system, supply of an inert gas from the first inert gas supply system and the second inert gas supply system, gas exhaust by the first exhaust system, and the like.

The controller 281 may be configured as a dedicated computer, or may be configured as a general-purpose computer. For example, the controller 281 according to the present embodiment can be configured by preparing an external memory (for example, a magnetic tape, a magnetic disk such as a flexible disk or a hard disk, an optical disk such as a CD or a DVD, a magneto-optical disk such as an MO, or a semiconductor memory such as a USB memory or a memory card) storing the above-described program, and installing the program in a general-purpose computer using the external memory.

A means for supplying the program to the computer is not limited to supply via the external memory. For example, the program may be supplied using a communication means such as the Internet or a dedicated line without going through the external memory. The memory and the external memory are configured as computer-readable recording media. Hereinafter, these are also collectively and simply referred to as a recording medium. In the present specification, the term "recording medium" may include only the memory alone, only the external memory alone, or both of these.

### (5) Substrate processing step

Next, as one step of the semiconductor manufacturing process, a substrate processing step of processing the substrate 200 using the substrate processing apparatus having the above-described configuration will be described. In the following description, the controller 281 controls operations of the units constituting the substrate processing apparatus.

Here, as the substrate processing step, a case where a thin film is formed on the substrate 200 will be described as an example. In particular, in the present embodiment, an example will be described in which a DCS gas is used as the source gas (first gas), an NH₃ gas is used as the reactant gas (second gas), and these gases are alternately supplied to form a SiN (silicon nitride) film serving as a silicon-containing film on the substrate 200.

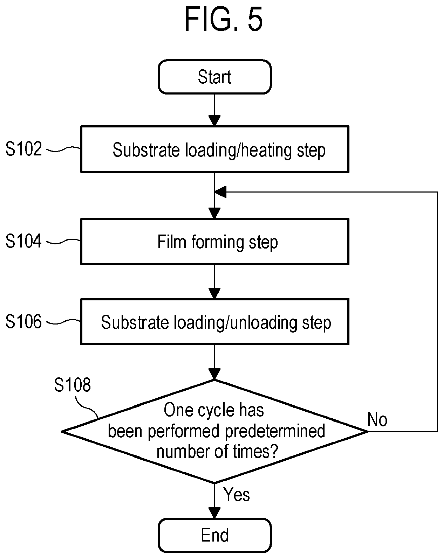

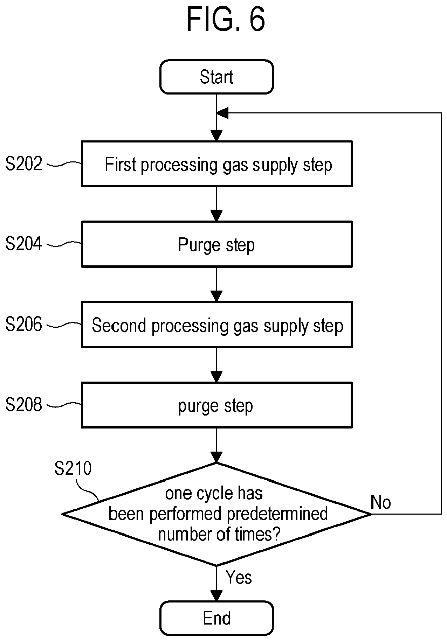

FIG. 5 is a flowchart illustrating an outline of the substrate processing step according to the first embodiment. FIG. 6 is a flowchart illustrating details of a film forming step in FIG. 5.

### (Substrate loading/heating step: S102)

In the substrate processing step, as illustrated in FIG. 5, first, a substrate loading/heating step (S102) is performed. In the substrate loading/heating step (S102), an atmosphere in the load lock chambers 122 and 123 is discharged through the exhaust pipe 262a, and a N₂ gas serving as an inert gas is supplied from the inert gas supply pipe 252a to the load lock chambers 122 and 123, whereby the load lock chambers 122 and 123 have a N₂ gas atmosphere. Furthermore, an atmosphere in the vacuum transfer chamber 103 is discharged through the exhaust pipe 261a, and a N₂ gas serving as an inert gas is supplied from the inert gas supply pipe 251a to the vacuum transfer chamber 103, whereby the vacuum transfer chamber 103 has a N₂ gas atmosphere. Then, the substrate 200 is loaded into each processing container 203 using the vacuum transfer robot 112 in the vacuum transfer chamber 103.

When the substrate 200 is loaded into the processing container 203, the vacuum transfer robot 112 is retracted to an outside of the processing container 203, and the gate valve 205 is closed to seal an inside of the processing container 203. Thereafter, the substrate mounting table 212 is raised to mount the substrate 200 on the substrate mounting surface 211 formed on the substrate mounting table 212. The substrate mounting table 212 is further raised to raise the substrate 200 to a processing position (substrate processing position) in the processing chamber 202.

When the substrate 200 is raised to the substrate processing position, the APC valve 223 is operated to cause the exhaust buffer chamber 209 and the vacuum pump 224 to communicate with each other. The APC valve 223 adjusts the conductance of the exhaust pipe 222 to control the exhaust flow rate of the exhaust buffer chamber 209 by the vacuum pump 224, and maintains the pressure of the processing chamber 202 communicating with the exhaust buffer chamber 209 at a predetermined pressure.

When the substrate 200 is mounted on the substrate mounting table 212, power is supplied to the heater 213 embedded in the substrate mounting table 212, and a surface of the substrate 200 is controlled to have a predetermined processing temperature. At this time, a temperature of the heater 213 is adjusted by controlling the degree of energization to the heater 213 on the basis of temperature information detected by a temperature sensor (not illustrated).

In this manner, in the substrate loading/heating step (S102), control is performed such that the inside of the processing chamber 202 has a predetermined processing pressure, and control is performed such that the surface temperature of the substrate 200 is a predetermined processing temperature. Here, the predetermined processing temperature and the predetermined processing pressure are a processing temperature and a processing pressure at which a SiN film can be formed by an alternate supply method in a film forming step (S104) described later. That is, the predetermined processing temperature and the predetermined processing pressure are a processing temperature and a processing pressure at which a source gas supplied in the first processing gas (source gas) supply step (S202) is not self-decomposed. Specifically, it is conceivable that the processing temperature is set to room temperature or higher and 500°C or lower, preferably room temperature or higher and 400°C or lower, and the processing pressure is set to 50 to 5000 Pa. The processing temperature and the processing pressure are also maintained in the film forming step (S104) described later.

In the substrate loading/heating step (S102), until the pressure in the processing chamber 202 reaches a predetermined processing pressure (that is, a pressure at which the substrate 200 is processed), a N₂ gas serving as an inert gas may be supplied from the third gas supply pipe 245a of the purge gas supply system 245 for pressure adjustment of the processing chamber 202. At this time, when the N₂ gas supplied from the third gas supply pipe 245a is obtained through the inert gas supply pipes 271a to 271d of the second inert gas supply system, a N₂ gas supplied to the vacuum transfer chamber 103 or the load lock chambers 122 and 123 is reused. Therefore, the usage amount (consumption amount) of the N₂ gas can be suppressed.

### (Film forming step: S104)

After the substrate loading/heating step (S102), next, the film forming step (S104) is performed. Hereinafter, the film forming step (S104) will be described in detail with reference to FIG. 6. The film forming step (S104) is, for example, cyclic processing of repeating a step of alternately supplying different processing gases.

### (First processing gas supply step: S202)

In the film forming step (S104), first, a first processing gas (source gas) supply step (S202) is performed. In the first processing gas supply step (S202), a DCS gas is supplied as a source gas (first gas) from the source gas supply system 243 into the processing chamber 202. The DCS gas supplied into the processing chamber 202 reaches a surface of the substrate 200 located at the substrate processing position. As a result, the DCS gas is brought into contact with the surface of the substrate 200 to form a silicon-containing layer serving as a "first element-containing layer" on the surface of the substrate 200. The silicon-containing layer is formed with a predetermined thickness and a predetermined distribution according to, for example, the pressure in the processing container 203, the flow rate of the DCS gas, the temperature of the substrate mounting table 212, time taken for passing through the processing chamber 202, and the like.

After a lapse of a predetermined time from start of supply of the DCS gas, the valve 243d is closed to stop supply of the DCS gas. In the first processing gas supply step (S202), the APC valve 223 controls the pressure in the processing chamber 202 to be a predetermined pressure.

### (Purge step: S204)

After the first processing gas supply step (S202), next, a N₂ gas serving as a purge gas is supplied from the purge gas supply system 245 to purge an atmosphere from the processing chamber 202 and the shower head 230. As a result, the DCS gas that cannot be bonded to the substrate 200 in the first processing gas supply step (S202) is removed from the processing chamber 202 by the vacuum pump 224.

At this time, the N₂ gas to be supplied to the processing chamber 202 is obtained through the inert gas supply pipes 271a to 271d of the second inert gas supply system. In this case, a N₂ gas supplied to the vacuum transfer chamber 103 or the load lock chambers 122 and 123 is reused. Therefore, the usage amount (consumption amount) of the N₂ gas can be suppressed.

When the N₂ gas is reused, by causing the N₂ gas to pass through the filter 270, a clean N₂ gas can be supplied to the processing chamber 202. For example, when the N₂ gas does not pass through the filter 270, an atmosphere in the transfer chamber (that is, the vacuum transfer chamber 103 or the load lock chambers 122 and 123) is supplied to the processing chamber 202 as it is, and impurities and the like may enter the processing chamber 202 to adversely affect processing in the processing chamber 202. Meanwhile, when the N₂ gas passes through the filter 270, impurities and the like are removed by the filter 270. Therefore, a clean N₂ gas can be supplied, and a possibility of adverse effects due to impurities and the like can be eliminated.

As the N₂ gas to be reused, it is preferable to mainly use a N₂ gas discharged from the vacuum transfer chamber 103. That is, when the N₂ gas is reused, the transfer chamber from which the N₂ gas is discharged is preferably the vacuum transfer chamber 103.

The load lock chambers 122 and 123 are located between the atmospheric transfer chamber 121 and the vacuum transfer chamber 103, and repeat state transition between an atmospheric pressure and a vacuum pressure. Therefore, when the load lock chambers 122 and 123 is caused to communicate with the atmospheric transfer chamber 121, a component (for example, an oxygen component) in the atmospheric transfer chamber 121 may enter the load lock chambers 122 and 123. If the component is supplied to the processing chamber 202, substrate processing may be adversely affected. In this regard, it is conceivable to use a high-performance filter as the filter 270, but in this case, there is a concern that cost may increase.

Meanwhile, the vacuum transfer chamber 103 communicates with the atmospheric transfer chamber 121 in a vacuum state. Therefore, when a N₂ gas discharged from the vacuum transfer chamber 103 is used, a clean N₂ gas can be used unlike the case of the load lock chambers 122 and 123, and substrate processing is not affected by impurities contained in the air. Therefore, the possibility of adverse effects on substrate processing can be eliminated without requiring the high-performance filter 270. In addition, since the filter 270 having a low removal level can be used, an increase in apparatus cost can be suppressed.

When a N₂ gas discharged from the vacuum transfer chamber 103 is used, the first exhaust system (first exhauster) that discharges the N₂ gas preferably further includes an inert gas exhaust pipe that discharges the N₂ gas. Specifically, out of branches of the exhaust pipe 261a bifurcated on a downstream side of the vacuum pump 261b, the branch of the exhaust pipe 261a not connected to the filter 270 (described as 261e in the drawing) discharges a N₂ gas to the outside. In this case, the ratio of impurities in an atmosphere discharged from the vacuum transfer chamber 103 can be reduced, which is suitable for supplying a clean N₂ gas. Such an exhaust configuration may be applied not only to discharge from the vacuum transfer chamber 103 but also to discharge from the load lock chambers 122 and 123.

In supplying a N₂ gas to the processing chamber 202, a N₂ gas flowing through the inert gas supply pipes 271a to 271d may be replenished with a N₂ gas from the inert gas replenishing pipes 273a to 273d connected to the inert gas supply pipes 271a to 271d, respectively. In this case, even when the N₂ gas is reused, the supply amount of the N₂ gas is not insufficient. In addition, the N₂ gas with which replenishment is performed from the inert gas replenishing pipes 273a to 273d can increase the cleanliness of the N₂ gas to be reused (that is, the N₂ gas discharged from the vacuum transfer chamber 103 and the like), which is suitable for eliminating a possibility of adverse effects on substrate processing.

### (Second processing gas supply step: S206)

After the purge step (S204) as described above is performed for a predetermined time, next, an NH₃ gas is supplied as the reactant gas (second gas) from the reactant gas supply system 244 into the processing chamber 202. The NH₃ gas may be brought into a plasma state by the RPU 244e, and may be emitted on a surface of the substrate 200 at the substrate processing position. As a result, the already formed silicon-containing layer is modified on the surface of the substrate 200, and for example, a SiN film which is a layer containing a Si element and a N element is formed.

Then, after a lapse of a predetermined time, the valve 244d is closed to stop the supply of the NH₃ gas. Also in the second processing gas supply step (S206), similarly to the first processing gas supply step (S202) described above, the APC valve 223 controls the pressure in the processing chamber 202 to be a predetermined pressure.

### (Purge step: S208)

After the second processing gas supply step (S206), a purge step (S208) is performed. Since operations of the units in the purge step (S208) are similar to those in the above-described purge step (S204), description thereof will be omitted here.

### (Determination step: S210)

When the purge step (S208) is ended, the controller 281 subsequently determines whether or not one cycle has been performed a predetermined number of times (n cycles) while the above-described series of processes (S202 to S208) is defined as the one cycle. Then, if the one cycle has not been performed a predetermined number of times, the one cycle from the first processing gas supply step (S202) to the purge step (S208) is repeated. Meanwhile, if the one cycle has been performed a predetermined number of times, the film forming step (S104) is ended.

As described above, in the film forming step (S104), by sequentially performing the steps from the first processing gas supply step (S202) to the purge step (S208), a SiN film having a predetermined thickness is deposited on the surface of the substrate 200. Then, by repeating one cycle a predetermined number of times while these steps are defined as the one cycle, a SiN film formed on the surface of the substrate 200 is controlled to have a desired thickness of film.

That is, in the film forming step (S104), in a state where there is the substrate 200 in the processing chamber 202, the processing gas supply systems (processing gas suppliers) of the source gas supply system 243 and the reactant gas supply system 244 alternately supply at least two types of processing gases (that is, the source gas and the reactant gas) to form a SiN film having a desired thickness of film on the surface of the substrate 200. Then, when these processing gases are discharged, the second inert gas supply system (second inert gas supplier) supplies a N₂ gas discharged from the vacuum transfer chamber 103 or the like to the processing chamber 202 through the inert gas supply pipes 271a to 271d. As a result, the N₂ gas discharged from the vacuum transfer chamber 103 or the like can be reused without affecting the processing gases, and as a result, the usage amount (consumption amount) of the N₂ gas can be suppressed.

In the film forming step (S104), the supply of the N₂ gas through the inert gas replenishing pipes 273a to 273d may be performed in parallel with supplying of the processing gas from the processing gas supply system (processing gas supplier). Even in this case, by reusing the N₂ gas discharged from the vacuum transfer chamber 103 or the like, the usage amount (consumption amount) of the N₂ gas can be suppressed.

### (Substrate loading/unloading step: S106)

After the film forming step (S104) as described above is ended, the substrate loading/unloading step (S106) is performed as illustrated in FIG. 5. In the substrate loading/unloading step (S106), the processed substrate 200 is unloaded to the outside of the processing container 203 in a reverse procedure to the substrate loading/heating step (S102) described above. Then, the next waiting unprocessed substrate 200 is loaded into the processing container 203 in a similar procedure to the substrate loading/heating step (S102). Thereafter, the film forming step (S104) is performed on the loaded substrate 200.

In the substrate loading/unloading step (S106), until the pressure in the processing chamber 202 reaches a predetermined pressure (that is, a pressure at which the processed substrate 200 can be unloaded), a N₂ gas may be supplied from the third gas supply pipe 245a of the purge gas supply system 245 for pressure adjustment of the processing chamber 202. At this time, when the N₂ gas supplied from the third gas supply pipe 245a is obtained through the inert gas supply pipes 271a to 271d of the second inert gas supply system, a N₂ gas discharged from the vacuum transfer chamber 103 or the like is reused. Therefore, the usage amount (consumption amount) of the N₂ gas can be suppressed.

### (Determination step: S108)

After the substrate loading/unloading step (S106) is ended, it is determined whether or not one cycle has been performed a predetermined number of times while the series of processes (S102 to S106) described above is defined as the one cycle, that is, whether or not the number of the substrates 200 processed in the film forming step (S104) has reached a predetermined number. Then, if the one cycle has not been performed a predetermined number of times, since the number of the processed substrates 200 has not reached a predetermined number, one cycle from the substrate loading/heating step (S102) to the substrate loading/unloading step (S106) is repeated. Meanwhile, if the one cycle has been performed a predetermined number of times, the substrate processing step is ended.

When the substrate processing step is ended, there is no substrate 200 in the processing container 203.

### (Cleaning step)

When the above-described substrate processing step is repeatedly performed, an unnecessary reactant such as a by-product may adhere to a wall surface in the processing container 203 (in particular, in the processing chamber 202). Therefore, after the substrate processing step is ended, a cleaning step is preferably performed on the processing chamber 202 at a predetermined timing (for example, after the substrate processing step is performed a predetermined number of times, after a predetermined number of substrates 200 are processed, after a predetermined time has elapsed from the previous cleaning processing, or the like).

In the cleaning step, the valve 248d is opened while the valves 243d, 244d, 245d, 246d, 247d, and 249d are closed. In this state, a cleaning gas is supplied to the processing chamber 202 from the cleaning gas supply source 248b of the cleaning gas supply system 248 via the third gas supply pipe 245a and the common gas supply pipe 242. Then, the supplied cleaning gas removes an extraneous matter (a reaction by-product and the like) in the buffer chamber 232 and the processing chamber 202.

As a result, in the processing chamber 202, for example, even when a by-product or the like adheres to a wall surface, the by-product or the like is removed by the cleaning processing performed at a predetermined timing.

At this time, the cleaning gas supply system 248 supplies the cleaning gas to the processing chamber 202 in a state where there is no substrate 200 in the processing container 203. In addition, the second inert gas supply system (second inert gas supplier) supplies a N₂ gas to the processing chamber 202. That is, the second inert gas supply system supplies the N₂ gas to the processing chamber 202 in parallel with the cleaning gas supplied by the cleaning gas supply system 248.

As a result, it is possible to reuse the N₂ gas while performing the cleaning processing on the processing chamber 202, and it is possible to suppress the usage amount (consumption amount) of the N₂ gas used in the cleaning step.

By the way, the substrate processing apparatus that performs the substrate processing step and the cleaning step described above is a so-called cluster type substrate processing apparatus including a plurality of processing modules 201a to 201d around the vacuum transfer chamber 103. The processing modules 201a to 201d include the processing chambers 202a to 202d that perform processing on the substrate 200, respectively, and a N₂ gas can be supplied to the processing chambers 202a to 202d through the inert gas supply pipes 271a to 271d, respectively. In this case, the second inert gas supply system (second inert gas supplier) that supplies the N₂ gas supplies the N₂ gas to a processing chamber 202 in operation (i.e., operating processing chamber 202), and does not supply the N₂ gas to a processing chamber 202 not in operation (i.e., non-operating processing chamber 202).

Here, the "non-operating processing chamber" refers to the processing chamber 202 during downtime. The "downtime" refers to, for example, a case where maintenance (component replacement or the like) is performed in a state where no gas flows. That is, "not operating" is a state in which gas supply (supply of a processing gas, an inert gas, or the like) to the processing chamber 202 is not performed at all.

As described above, when the supply of the N₂ gas to the plurality of processing chambers 202a to 202d is switched according to the operating state of each of the processing chambers 202a to 202d, it is possible to perform the substrate processing step or the cleaning step in parallel with maintenance of the processing chamber 202 during the downtime, and it is possible to implement an efficient apparatus operation. Moreover, since the N₂ gas is reused in the substrate processing step or the cleaning step, the usage amount (consumption amount) of the N₂ gas can be suppressed.

### (6) Effects of embodiment

According to the present embodiment, one or more effects described below are exhibited.
(a) According to the present embodiment, since the second inert gas supply system supplies the N₂ gas serving as the inert gas discharged from the transfer chamber to the processing chamber 202, the N₂ gas can be reused, and as a result, the usage amount (consumption amount) of the N₂ gas can be suppressed.
(b) According to the present embodiment, when the N₂ gas is reused, by causing the N₂ gas to pass through the filter 270, a clean N₂ gas can be supplied to the processing chamber 202. That is, since impurities and the like are removed by the filter 270, a possibility of adverse effects due to impurities and the like on substrate processing can be eliminated.
(c) According to the present embodiment, in the film forming step (S104), at least two types of processing gases are alternately supplied in a state where there is the substrate 200 in the processing chamber 202 to form a film on a surface of the substrate 200, and when the processing gases are discharged or in parallel with supply of the processing gases, the N₂ gas to be reused is supplied as a purge gas. As a result, the N₂ gas can be reused without affecting the processing gases, and as a result, the usage amount (consumption amount) of the N₂ gas can be suppressed.
(d) According to the present embodiment, the N₂ gas to be reused is supplied for pressure adjustment until the pressure of the processing chamber 202 reaches a pressure at which the substrate 200 is processed in the substrate loading/heating step (S102) or until the pressure of the processing chamber 202 reaches a pressure at which the substrate 200 can be unloaded in the substrate loading/unloading step (S106). As a result, even when the N₂ gas is used for pressure adjustment, the N₂ gas can be reused, and as a result, the usage amount (consumption amount) of the N₂ gas can be suppressed.
(e) According to the present embodiment, since the transfer chamber from which the N₂ gas to be reused is discharged is the vacuum transfer chamber 103, a clean N₂ gas can be used, and substrate processing is not affected by impurities contained in the air. Therefore, the possibility of adverse effects on substrate processing can be eliminated without requiring the high-performance filter 270. In addition, since the filter 270 having a low removal level can be used, an increase in apparatus cost can be suppressed.
(f) According to the present embodiment, since the N₂ gas to be reused is supplied to the processing chamber 202 in parallel with the cleaning gas in the cleaning step, the N₂ gas can be reused while the cleaning processing is performed on the processing chamber 202, and the usage amount (consumption amount) of the N₂ gas used in the cleaning step can be suppressed.
(g) According to the present embodiment, when the N₂ gas to be reused can be supplied to each of the plurality of processing chambers 202a to 202d, the N₂ gas is supplied to the operating processing chamber 202, and the N₂ gas is not supplied to the non-operating processing chamber 202. As described above, when the supply of the N₂ gas is switched according to the operating state of each of the processing chambers 202a to 202d, it is possible to perform the substrate processing step or the cleaning step in parallel with maintenance of the processing chamber 202 during the downtime, and it is possible to implement an efficient apparatus operation. Moreover, since the N₂ gas is reused in the substrate processing step or the cleaning step, the usage amount (consumption amount) of the N₂ gas can be suppressed.
(h) According to the present embodiment, it is possible to perform replenishment with a N₂ gas from the inert gas replenishing pipes 273a to 273d connected to the inert gas supply pipes 271a to 271d. In this case, even when the N₂ gas is reused, the supply amount of the N₂ gas is not insufficient. In addition, the N₂ gas with which replenishment is performed from the inert gas replenishing pipes 273a to 273d can increase the cleanliness of the N₂ gas to be reused (that is, the N₂ gas discharged from the vacuum transfer chamber 103 and the like), which is suitable for eliminating a possibility of adverse effects on substrate processing.
(i) According to the present embodiment, the N₂ gas can be discharged through the exhaust pipe 261a not connected to the filter 270 to the outside. In this case, the ratio of impurities in an atmosphere discharged from the vacuum transfer chamber 103 can be reduced, which is suitable for supplying a clean N₂ gas.

### <Second Embodiment>

Next, a second embodiment of the present disclosure will be specifically described. Here, a difference from the above-described first embodiment will be mainly described, and description of other points will be omitted.

In the present embodiment, a configuration of a second inert gas supply system (second inert gas supplier) is different from that of the first embodiment.

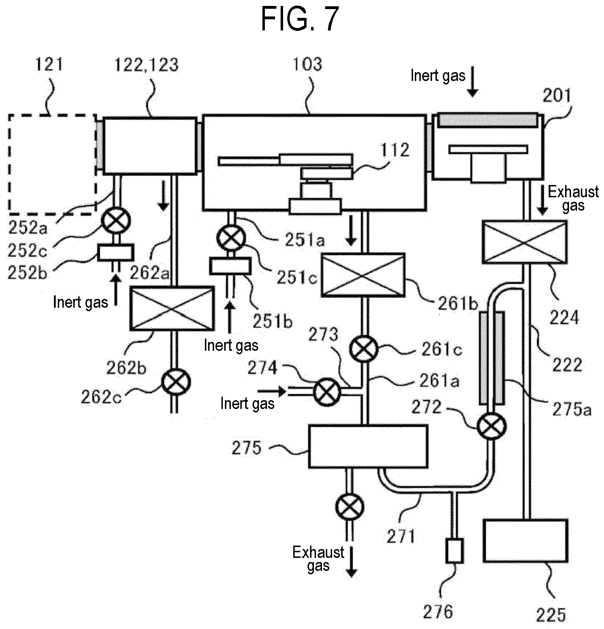

FIG. 7 is an explanatory diagram schematically illustrating a configuration example of main components of a gas supply system and a gas exhaust system of a substrate processing apparatus according to the second embodiment.

### (Second inert gas supply system)

The substrate processing apparatus described in the present embodiment can supply an inert gas discharged from a transfer chamber to a downstream portion of a processing chamber 202 formed in a processing module 201. Although only one processing module 201 is illustrated in the illustrated example, a plurality of processing modules 201a to 201d may be included, and a second inert gas supply system can be similarly configured for each of the processing modules 201a to 201d similarly to the case of the first embodiment. That is, here, in order to simplify the description, the following description will be given by taking one processing module 201 as an example.

The downstream portion of the processing chamber 202 is an exhaust pipe 222 disposed between a vacuum pump 224 and a scrubber 225, particularly a portion near the vacuum pump 224 on a downstream side in the exhaust pipe 222. That is, in the present embodiment, the exhaust pipe 222 serving as a processing chamber exhaust pipe is disposed between the vacuum pump 224 serving as an exhaust pump that discharges an atmosphere from the processing chamber 202 and the scrubber 225 serving as a detoxification apparatus that purifies an exhaust gas discharged by the vacuum pump 224, and an inert gas discharged from the transfer chamber can be supplied to a portion near the vacuum pump 224 on a downstream side of the vacuum pump 224 in the exhaust pipe 222.

Therefore, in the present embodiment, on a downstream side of an exhaust pipe 261a constituting a first exhaust system, a heat exchanger 275 is disposed. The heat exchanger 275 functions as a heater that heats an inert gas to be supplied to the exhaust pipe 222. A heating mechanism 275a such as a heater that heats piping may be disposed instead of the heat exchanger 275 as long as the heating mechanism 275a can heat an inert gas.

To the heat exchanger 275, an inert gas supply pipe 271 is connected. The inert gas supply pipe 271 includes a valve 272, and a downstream end thereof is connected to the exhaust pipe 222 (that is, a downstream portion of the processing chamber 202). As a result, an inert gas discharged by a first exhauster is supplied to the exhaust pipe 222 which is a downstream portion of the processing chamber 202 through the inert gas supply pipe 271.

Mainly, the inert gas supply pipe 271 and the valve 272 constitute a second inert gas supply system (second inert gas supplier). The second inert gas supply system may include the heat exchanger 275, and communicates with the first exhaust system via the heat exchanger 275.

To an upstream side of the heat exchanger 275, an inert gas replenishing pipe 273 may be connected. The inert gas replenishing pipe 273 includes a valve 274, and further includes an inert gas supply source (not illustrated) on an upstream side thereof. The inert gas supply source is disposed for replenishing the inert gas replenishing pipe 273 with an inert gas (for example, a N₂ gas, a He gas, a Ne gas, or an Ar gas) flowing through the inert gas replenishing pipe 273, and a purge gas supply source 245b of a purge gas supply system 245 may be used.

Mainly, the inert gas replenishing pipe 273 and the valve 274 constitute an inert gas replenishing system (inert gas replenisher) capable of replenishing an inert gas. The inert gas replenishing system may be included in the second inert gas supply system (second inert gas supplier).

### (Substrate processing step)

Next, a substrate processing step performed using the second inert gas supply system as described above will be described.

In the film forming step (S104) in the substrate processing step, similarly to the case of the first embodiment, at least two types of processing gases (that is, a source gas and a reactant gas) are alternately supplied in a state where there is the substrate 200 in the processing chamber 202 to form a film on a surface of the substrate 200. In this case, in a gas exhaust system that discharges an atmosphere from the processing chamber 202, at least two types of processing gases flow to a downstream side of the vacuum pump 224 (that is, the exhaust pipe 222 on a downstream side of the vacuum pump 224).

At this time, when the processing gases flowing through the exhaust pipe 222 are cooled, a by-product may be generated in the exhaust pipe 222 on a downstream side of the vacuum pump 224. When a by-product is generated, the by-product is deposited in the exhaust pipe 222 between the vacuum pump 224 and the scrubber 225 to increase a pressure loss, which may reduce an exhaust pressure of the vacuum pump 224.

Therefore, in the present embodiment, in order to avoid an exhaust gas from solidifying and blocking the exhaust pipe 222, a N₂ gas serving as an inert gas discharged from the vacuum transfer chamber 103 is heated by the heat exchanger 275, and the heated N₂ gas is supplied into the exhaust pipe 222 on a downstream side of the vacuum pump 224 through the inert gas supply pipe 271. As a result, the exhaust gas can be prevented from solidifying in the exhaust pipe 222, and generation of a by-product is suppressed. As a result, an exhaust pressure of the vacuum pump 224 is maintained. In addition, as the N₂ gas supplied to the exhaust pipe 222, the N₂ gas supplied to the vacuum transfer chamber 103 is reused. Therefore, the usage amount (consumption amount) of the N₂ gas can be suppressed.

Specifically, in the substrate processing step, first, the heat exchanger 275 is operated before a substrate 200 is processed in the processing chamber 202. As described above, by allowing the N₂ gas supplied to the exhaust pipe 222 to be heated before an exhaust gas discharged from the processing chamber 202 passes through the vacuum pump 224, it is possible to reliably avoid the exhaust gas flowing through the exhaust pipe 222 from solidifying.

Thereafter, in the film forming step (S104), as described in the first embodiment, at least two types of processing gases (that is, a source gas and a reactant gas) are alternately supplied in a state where there is the substrate 200 in the processing chamber 202 to form a film on a surface of the substrate 200. In parallel with supply of the processing gases to the processing chamber 202, a N₂ gas heated by the heat exchanger 275 is supplied into the exhaust pipe 222. That is, in the exhaust pipe 222, the heated N₂ gas is used for heating and diluting the processing gases discharged from the processing chamber 202.

As described above, by supplying the heated N₂ gas into the exhaust pipe 222 in parallel with supply of the processing gases to the processing chamber 202, supply timings thereof coincide with each other. For example, when the processing gases and the heated N₂ gas are separately supplied at different timings, the temperature of the processing gases remains low, and thus the processing gases may solidify in the exhaust pipe 222. On the other hand, when the supply timings coincide with each other, the processing gases are heated and diluted by the heated N₂ gas, and it is possible to more reliably prevent the exhaust gas from solidifying.

In addition, for example, even when the processing gases contain a combustible substance such as hydrogen, combustion, explosion, and the like can be prevented in advance by dilution as long as the processing gases can be diluted. Therefore, the exhaust pipe 222 can be constituted using a piping material having a low rigidity.

In addition, in the film forming step (S104), as described in the first embodiment, at least two types of processing gases (that is, a source gas and a reactant gas) are alternately supplied, and an atmosphere in the processing chamber 202 is purged between the supplies of the processing gases. In parallel with purge of the atmosphere in the processing chamber 202, a N₂ gas heated by the heat exchanger 275 is supplied into the exhaust pipe 222. That is, the heated N₂ gas is supplied into the exhaust pipe 222 as a purge gas.

As described above, by supplying the heated N₂ gas into the exhaust pipe 222 in parallel with purge of the atmosphere in the processing chamber 202, not only an atmosphere in the processing chamber 202 but also an atmosphere in the inside of the exhaust pipe 222 on a downstream side of the vacuum pump 224 is purged. Therefore, it is possible to prevent the processing gases discharged from the processing chamber 202 from staying in the exhaust pipe 222 as residual gases, thereby preventing the exhaust gas from solidifying in the exhaust pipe 222.

In the substrate loading/heating step (S102) performed prior to the film forming step (S104), the N₂ gas heated by the heat exchanger 275 may be supplied into the exhaust pipe 222 until the pressure of the processing chamber 202 reaches a predetermined processing pressure (that is, a pressure at which the substrate 200 is processed).

Furthermore, in the substrate loading/unloading step (S106) performed after the film forming step (S104), the N₂ gas heated by the heat exchanger 275 may be supplied into the exhaust pipe 222 until the pressure of the processing chamber 202 reaches a predetermined pressure (that is, a pressure at which the processed substrate 200 can be unloaded). That is, also in this case, the heated N₂ gas is used for pressure adjustment in the exhaust pipe 222.

As described above, when the heated N₂ gas is used for pressure adjustment in the exhaust pipe 222, it is possible to reliably prevent backflow of a gas remaining in the exhaust pipe 222 into the processing chamber 202 by pressure adjustment while preventing sticking of the gas.

In a case where a plurality of the processing chambers 202 that performs processing on the substrate 200 is disposed, the heated N₂ gas is supplied to a downstream portion of the operating processing chamber 202, and the heated N₂ gas is not supplied to a downstream portion of the non-operating processing chamber 202.

As described above, when the supply of the N₂ gas to the plurality of processing chambers 202 is switched according to the operating state of each of the processing chambers 202, it is possible to perform the substrate processing step or the cleaning step in parallel with maintenance of the processing chamber 202 during the downtime, and it is possible to implement an efficient apparatus operation. Moreover, since the N₂ gas is reused in the substrate processing step or the cleaning step, the usage amount (consumption amount) of the N₂ gas can be suppressed.

### (Effects of embodiment)

According to the present embodiment, one or more effects described below are exhibited.

(j) According to the present embodiment, the second inert gas supply system supplies a N₂ gas serving as an inert gas discharged from the transfer chamber to a downstream portion of the processing chamber 202. Therefore, when generation of a by-product in the exhaust pipe 222 is suppressed, the N₂ gas can be reused, and as a result, the usage amount (consumption amount) of the N₂ gas can be suppressed.

(k) According to the present embodiment, a N₂ gas heated by the heat exchanger 275 is supplied into the exhaust pipe 222 which is a downstream portion of the processing chamber 202. Therefore, temperature lowering of the exhaust gas in the exhaust pipe 222 can be suppressed, and the exhaust gas can be more reliably prevented from solidifying. That is, it is possible to reliably avoid the exhaust gas flowing through the exhaust pipe 222 from solidifying, and generation of a by-product in the exhaust pipe 222 is thereby suppressed. As a result, an exhaust pressure of the vacuum pump 224 is maintained.

(l) According to the present embodiment, since the heat exchanger 275 is operated before the substrate 200 is processed in the processing chamber 202, a N₂ gas can be heated before an exhaust gas discharged from the processing chamber 202 passes through the vacuum pump 224, and the exhaust gas flowing through the exhaust pipe 222 can be reliably avoided from solidifying.

(m) According to the present embodiment, in the film forming step (S 104), in parallel with supply of the processing gases to the processing chamber 202, a N₂ gas heated by the heat exchanger 275 is supplied into the exhaust pipe 222. As described above, when a timing of supplying the processing gases to the processing chamber 202 coincides with a timing of supplying the heated N₂ gas into the exhaust pipe 222, the processing gases are heated and diluted by the heated N₂ gas, and it is possible to more reliably prevent the exhaust gas from solidifying. In addition, the exhaust pipe 222 can be constituted using a piping material having a low rigidity as long as the processing gases can be diluted.

(n) According to the present embodiment, in the film forming step (S104), in parallel with purge of the atmosphere in the processing chamber 202, a N₂ gas heated by the heat exchanger 275 is supplied into the exhaust pipe 222. As described above, not only an atmosphere in the processing chamber 202 but also an atmosphere in the inside of the exhaust pipe 222 on a downstream side of the vacuum pump 224 is purged, whereby it is possible to prevent the processing gases discharged from the processing chamber 202 from staying in the exhaust pipe 222 as residual gases, thereby preventing the exhaust gas from solidifying in the exhaust pipe 222.

(o) According to the present embodiment, a N₂ gas heated by the heat exchanger 275 is supplied into the exhaust pipe 222 until the pressure of the processing chamber 202 reaches a pressure at which the substrate 200 is processed in the substrate loading/heating step (S 102) or until the pressure of the processing chamber 202 reaches a pressure at which the substrate 200 can be unloaded in the substrate loading/unloading step (S106). As described above, by using the heated N₂ gas for pressure adjustment in the exhaust pipe 222, it is possible to prevent sticking of the gas remaining in the exhaust pipe 222.

(p) According to the present embodiment, in a case where a plurality of the processing chambers 202 is disposed, the heated N₂ gas is supplied to a downstream portion of the operating processing chamber 202, and the heated N₂ gas is not supplied to a downstream portion of the non-operating processing chamber 202. As described above, when the supply of the N₂ gas to the plurality of processing chambers 202 is switched according to the operating state of each of the processing chambers 202, it is possible to perform the substrate processing step or the cleaning step in parallel with maintenance of the processing chamber 202 during the downtime, and it is possible to implement an efficient apparatus operation. Moreover, since the N₂ gas is reused in the substrate processing step or the cleaning step, the usage amount (consumption amount) of the N₂ gas can be suppressed.

### <Third Embodiment>

Next, a third embodiment of the present disclosure will be specifically described. Here, a difference from the above-described first or second embodiment will be mainly described, and description of other points will be omitted.

In a substrate processing apparatus described in the present embodiment, in addition to the configuration described in the first embodiment or the second embodiment, a detector that detects the concentration of impurities is disposed in either a first exhaust system (first exhauster) that discharges an atmosphere from a transfer chamber or a second inert gas supply system (second inert gas supplier) that supplies a N₂ gas serving as an inert gas to a processing chamber 202 or a downstream portion of the processing chamber 202. In FIG. 4, detectors 276a and 276d correspond to the detector. In FIG. 7, a detector 276 corresponds to the detector. The detector is, for example, an O₂ sensor that detects the concentration of an oxygen component (O₂ component) which is an impurity.

It is conceivable that a N₂ gas supplied to a transfer chamber (that is, a vacuum transfer chamber 103 or load lock chambers 122 and 123) contains an oxygen component. In particular, an oxygen component may enter the load lock chambers 122 and 123 as an impurity that may adversely affect substrate processing when a gas in the load lock chambers 122 and 123 is replaced with the air.

Therefore, in the present embodiment, the impurity concentration of the N₂ gas discharged from the transfer chamber or the N₂ gas supplied to the processing chamber 202 or a downstream portion thereof is detected using the detector. In this manner, it is possible to quantitatively grasp how much impurity (oxygen component) is contained in the N₂ gas to be supplied to the processing chamber 202 or a downstream portion thereof.

In a case where the impurity concentration detected by the detector is a predetermined value or more, the second inert gas supply system that supplies a N₂ gas to the processing chamber 202 or a downstream portion thereof does not supply the N₂ gas. Here, the predetermined value which is a determination reference is a value corresponding to an impurity concentration that adversely affects substrate processing, and is determined in advance. As described above, when the N₂ gas is not supplied in a case where the impurity concentration is the predetermined value or more, it is possible to avoid, in advance, generation of the substrate 200 to be discarded as a result of substrate processing in the processing chamber 202.

In addition, in a case where the impurity concentration detected by the detector is the predetermined value or more, the N₂ gas is not supplied, and the N₂ gas may be supplied from an inert gas replenisher capable of replenishing the N₂ gas. That is, since the impurity concentration of the N₂ gas discharged from the transfer chamber is the predetermined value or more, the N₂ gas is not supplied to the processing chamber 202 or a downstream portion thereof. On the other hand, an inert gas replenishing pipe 273 is connected to an inert gas supply pipe 271, and replenishment with the N₂ gas from the inert gas replenishing pipe 273 is possible. Therefore, the N₂ gas with which replenishment is performed from the inert gas replenishing pipe 273 is supplied to the processing chamber 202 or a downstream portion thereof instead of the N₂ gas discharged from the transfer chamber. In this manner, it is possible to continue substrate processing in the processing chamber 202 using the N₂ gas with which replenishment is performed from the inert gas replenishing pipe 273 while generation of the substrate 200 to be discarded is avoided in advance, and as a result, an improvement in the yield rate of the substrate processing on the substrate 200 can be expected.

According to the present embodiment described above, in addition to the effects described in the first embodiment or the second embodiment, the following effects are exhibited.

(q) According to the present embodiment, by including the detector that detects the impurity concentration, it is possible to quantitatively grasp how much impurity (oxygen component) is contained in the N₂ gas to be supplied to the processing chamber 202 or a downstream portion thereof. As a result, for example, in a case where the impurity concentration is the predetermined value or more, the N₂ gas is not supplied, whereby it is possible to avoid, in advance, generation of the substrate 200 to be discarded as a result of substrate processing in the processing chamber 202. In addition, for example, in a case where the impurity concentration is the predetermined value or more, by supplying the N₂ gas with which replenishment is performed from the inert gas replenishing pipe 273 to the processing chamber 202 or a downstream portion thereof instead of the N₂ gas discharged from the transfer chamber, it is possible to continue substrate processing in the processing chamber 202 while avoiding generation of the substrate 200 to be discarded in advance, and it is possible to expect an improvement in the yield rate of substrate processing on the substrate 200.

### <Other Embodiment>

The embodiments of the present disclosure have been specifically described above, but the present disclosure is not limited to the above-described embodiments, and various modifications can be made without departing from the gist of the present disclosure.

For example, in each of the embodiments described above, in the film forming processing performed by the substrate processing apparatus, the case has been exemplified in which the DCS gas is used as the first element-containing gas (first gas), the NH₃ gas is used as the second element-containing gas (second gas), and the DCS gas and the NH₃ gas are alternately supplied to form the SiN film on the substrate 200, but the present disclosure is not limited thereto. That is, the processing gas used for the film forming processing is not limited to the DCS gas, the NH₃ gas, or the like, and another type of thin film may be formed using another type of gas. Furthermore, even in a case where three or more types of processing gases are used, the present disclosure can be applied as long as the film forming processing is performed by alternately supplying the three or more types of processing gases. Specifically, as the first element, for example, various elements such as Ti, Zr, and Hf may be used instead of Si. As the second element, for example, O may be used instead of N.

In addition, for example, in each of the above-described embodiments, the film forming processing has been described as an example of the processing performed by the substrate processing apparatus, but the present disclosure is not limited thereto. That is, the present disclosure can also be applied to film forming processing other than the thin film forming processing exemplified in each of the embodiments in addition to the film forming processing exemplified in each of the embodiments. In addition, the specific content of the substrate processing may be any content, and the present disclosure can be applied not only to the film forming processing but also to other substrate processing such as annealing processing, diffusing processing, oxidizing processing, nitriding processing, or lithography processing. Furthermore, the present disclosure can also be applied to, for example, another substrate processing apparatus such as an annealing processing apparatus, an etching apparatus, an oxidizing processing apparatus, a nitriding processing apparatus, an exposure apparatus, a coating apparatus, a drying apparatus, a heating apparatus, or a processing apparatus using plasma. In addition, in the present disclosure, these apparatuses may be mixed. In addition, a part of a configuration of one embodiment can be replaced with a configuration of another embodiment, and a configuration of one embodiment can be added to a configuration of another embodiment. In addition, to a part of a configuration of each of the embodiments, another configuration can be added, a part of a configuration of each of the embodiments can be deleted, or a part of a configuration of each of the embodiments can be replaced with another configuration.

The present disclosure can reduce a consumption amount of an inert gas.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the features of the disclosures. The accompanying claims and their equivalents are intended to cover such forms or modifications as would fall within the scope of the disclosures.

## Claims

1. A substrate processing apparatus comprising:
at least one processing chamber in which a substrate is processed;
a processing gas supplier configured to supply a processing gas to the at least one processing chamber;
a transfer chamber communicable with the at least one processing chamber;
a first inert gas supplier configured to supply an inert gas to the transfer chamber;
a first exhauster configured to discharge an atmosphere from the transfer chamber; and
a second inert gas supplier configured to supply the inert gas discharged by the first exhauster to the at least one processing chamber or a downstream portion of the at least one processing chamber.

2. The substrate processing apparatus of claim 1, further comprising a filter disposed on a downstream of the first exhauster,
wherein the first exhauster communicates with the second inert gas supplier via the filter.

3. The substrate processing apparatus of claim 1, wherein the processing gas supplier is configured to alternately supply at least two types of processing gases in a state where there is a substrate in the at least one processing chamber, and
the second inert gas supplier is configured to supply the inert gas when the processing gases supplied to the at least one processing chamber are discharged or in parallel with supplying of the processing gases by the processing gas supplier.

4. The substrate processing apparatus of claim 1, further comprising a cleaning gas supplier configured to supply a cleaning gas to the at least one processing chamber,
wherein the cleaning gas supplier is configured to supply the cleaning gas in a state where there is no substrate in the at least one processing chamber, and
the second inert gas supplier is configured to supply the inert gas in parallel with supplying of the cleaning gas by the cleaning gas supplier.

5. The substrate processing apparatus of claim 1,
wherein the at least one processing chamber comprises a plurality of processing chambers,
wherein the second inert gas supplier is capable of supplying the inert gas to the plurality of processing chambers, configured to supply the inert gas to a processing chamber in operation, and configured not to supply the inert gas to a processing chamber not in operation.

6. The substrate processing apparatus of claim 1, wherein the downstream portion of the at least one processing chamber is a processing chamber exhaust pipe disposed between an exhaust pump configured to discharge an atmosphere from the at least one processing chamber and a detoxification apparatus configured to purify an exhaust gas discharged by the exhaust pump, and
the second inert gas supplier comprises a heater configured to heat the inert gas to be supplied to the processing chamber exhaust pipe.

7. The substrate processing apparatus of claim 6, wherein the heater is configured to operate before a substrate is processed by the substrate processing apparatus.

8. The substrate processing apparatus of claim 6, wherein the processing gas supplier is configured to supply a processing gas in a state where there is a substrate is in the at least one processing chamber, and
the second inert gas supplier is configured to supply the inert gas heated by the heater to the processing chamber exhaust pipe in parallel with supplying of the processing gas by the processing gas supplier.

9. The substrate processing apparatus of claim 6, wherein at least two types of processing gases are alternately supplied to the at least one processing chamber by the processing gas supplier, and an atmosphere in the at least one processing chamber is purged between the supplies of the two types of processing gases, and
the second inert gas supplier supplies the inert gas heated by the heater to the processing chamber exhaust pipe in parallel with the purge.

10. The substrate processing apparatus of claim 6, wherein the second inert gas supplier supplies, before a substrate is processed, the inert gas heated by the heater to the processing chamber exhaust pipe until a pressure of the at least one processing chamber reaches a pressure for processing the substrate in the at least one processing chamber, or until the pressure of the at least one processing chamber reaches a pressure at which a substrate can be unloaded after the substrate is processed in the at least one processing chamber.

11. The substrate processing apparatus of claim 6,
wherein the at least one processing chamber comprises a plurality of processing chambers,
wherein the second inert gas supplier is capable of supplying the inert gas to downstream portions of the plurality of processing chambers, configured to supply the inert gas to a downstream portion of a processing chamber in operation, and configured not to supply the inert gas to a downstream portion of a processing chamber not in operation.

12. The substrate processing apparatus of claim 1, wherein the first exhauster or the second inert gas supplier comprises a detector configured to detect a concentration of impurities.

13. The substrate processing apparatus of claim 12, wherein the second inert gas supplier does not supply the inert gas in a case where the concentration detected by the detector is a predetermined value or more.

14. A method of manufacturing a semiconductor device, the method comprising:
supplying an inert gas to a transfer chamber communicable with at least one processing chamber in which a substrate is processed;
discharging an atmosphere from the transfer chamber;
supplying the inert gas discharged from the transfer chamber to the at least one processing chamber or a downstream portion of the at least one processing chamber; and
processing a substrate in the at least one processing chamber.

15. A program causing a substrate processing apparatus to execute:
supplying an inert gas to a transfer chamber communicable with at least one processing chamber in which a substrate is processed;
discharging an atmosphere from the transfer chamber;
supplying the inert gas discharged from the transfer chamber to the at least one processing chamber or a downstream portion of the at least one processing chamber; and
processing a substrate in the at least one processing chamber, with a computer.
